Europäisches Patentamt

European Patent Office

Office européen des brevets

(11) Publication number: **0 108 258**
**B1**

# EUROPEAN PATENT SPECIFICATION

(45) Date of publication of patent specification: **10.05.89**

(51) Int. Cl.⁴: **G 11 B 7/26, G 11 B 7/24** // G03F7/20

(21) Application number: **83109976.7**

(22) Date of filing: **05.10.83**

(54) **A master disk for optical disk manufacture, and a method and the system for manufacturing the same.**

(30) Priority: **08.10.82 JP 176249/82**

(43) Date of publication of application:
**16.05.84 Bulletin 84/20**

(45) Publication of the grant of the patent:
**10.05.89 Bulletin 89/19**

(84) Designated Contracting States:
**DE FR GB NL**

(56) References cited:
**EP-A-0 017 289**
**EP-A-0 039 094**
**EP-A-0 099 085**
**DE-A-2 026 805**
**DE-A-2 355 446**
**GB-A-2 091 028**
**PATENTS ABSTRACTS OF JAPAN, vol. 6, no. 156(P-135)(1034), 17th August 1982 & JP-A-5774834**
**PATENTS ABSTRACTS OF JAPAN, vol. 6, no. 59(P-110)(937), 16th April 1982 & JP-A-56169235**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Ando, Hideo**
**357-16, Hodokubo**
**Hino-shi Tokyo (JP)**

(74) Representative: **Henkel, Feiler, Hänzel & Partner**
**Möhlstrasse 37**
**D-8000 München 80 (DE)**

Courier Press, Leamington Spa, England.

## Description

This invention relates to a master disk for optical disks capable of reproducing and/or recording information and a method and system for manufacturing the same.

Optical disks have been developed which may be applied in various fields as information carriers, from which information may be read out or reproduced and onto which information may be recorded. Such optical disks may include, for example, reproduction-type disks, such as the so-called compact disks for digital audio disk systems; video disks for optical video disks systems; and recording/reproduction-type disks for video file systems or computer output memory systems.

In such optical disks, a tracking guide is formed before recording information onto the optical disk for high-density recording, and pre-pits or preformation pits, such as codes representing the track number and sector number, are pre-formed to specify the recording or readout region. In a conventional information recording/reproducing system, the track number and sector number are read out from the pre-pits while tracing the tracking guide with a laser beam. Subsequently, information pits are formed and information is read out therefrom.

In the conventional optical disk, tracking guides are discontuously or intermittently formed along its circumference. Flat regions between the circumferential tracking guides are defined as regions in which the information pits are to be formed. Thus, in writing information to form the information pits in the optical disk, there is the risk that the laser beam may deviate from a predetermined track between the tracking guides, and that the information pits may fail to be formed in the prescribed regions. In reading out information from the optical disk in which information pits are formed, rows of information pits between the tracking guides function in the same manner as the tracking guides. Thus, the information pits are traced by the laser beam. However, since the information pits have depths which differ from that of the tracking guide, the rows of information pits have a limited capacity to urge the laser beam to trace the predetermined track. Thus, the laser beam may often deviate from the predetermined track, causing frequent errors.

Regarding the conventional optical disk, moreover, the combination of the width and depth of the pre-pits, and the tracking guide are not fully considered. Thus, information is not read out from the information pits and the pre-pits with satisfactory sensitivity while the tracking guide is being detected.

In order to solve the above-mentioned problems, the present inventors have proposed, as disclosed in EP—A—99085, filed on July 8, 1983, an optical disk wherein the pre-pits are formed in the bottom surface of a groove serving as the tracking guide, the width thereof being made smaller than that of the tracking guide. According to this optical disk, it is possible to cause an increase in the density of information to be recorded onto the optical disk and also to trace the tracking guide of the optical disk with high precision. However, in the process for manufacturing a master disk for use in the manufacture of such optical disks, when a two step process is used to form the tracking guide and pre-pits, namely when the pre-pits are formed in the tracking guide after the execution of the stop for forming this guide, there is the risk of failure of the pre-pits with a prescribed width and depth formed with high precision in the tracking guide. There is also the risk that the manufacturing of the optical disks will become complicated. For this reason, in the manufacturing of optical disks, it is necessary that the pre-pits be formed with a prescribed width and depth in the tracking guide while this tracking guide is being formed.

In prior art document "Patent Abstracts of Japan", Volume 6, No. 156 (P-135) (1034), 17th August 1982, discloses an optical disk of two-layered structure and a tracking guide having a depth of $\lambda/8$. The tracking guide is formed by irradiating the upper metal layer with a laser beam, thereby deforming the lower thermoplastic resin layer. To record information in the disk, the metal layer is irradiated by the laser beam which has a greater light intensity than the laser beam used when forming the tracking guide. As a result the metal layer is removed to form information pits.

Further, prior art document "Patent Abstract of Japan", Vol. 6, No. 59 (P-110) (937), 16th April 1982, discloses a manufacture method of an original optical disk. In this method a first photoresist layer having a thickness of $\lambda/8$ is formed on a glass disk. While the disk is rotated a tracking groove extending to the disk is made with the laser beam. Thus, a second $\lambda/8$ thickness photoresist layer is formed over the first layer and while the disk is rotated, only an index groove is irradiated with the laser beam by tracking the tracking groove to form a signal groove and a hole extending to the disk. Thus, the resist layers are only removed with the laser beam until the groove and hole reach the disk so that only a control over a driving current is required.

It is an object of the present invention to provide a master disk which is suitable for manufacturing optical disks having a tracking guide and pre-pits with a prescribed width and depth.

Another object of the present invention is to provide a method for manufacturing a master disk that is suitable in the manufacture of optical disks each having a tracking guide and pre-pits with prescribed width and depth, which permits precise formation, in the same process step, of a groove corresponding to the tracking guide, and recesses corresponding to the pre-pits, of the optical disks.

Still another object of the present invention is to provide a system for manufacturing a master disk, which permits the precise formation, in the same process step, of a groove corresponding to the tracking guide and recesses corresponding to the pre-pits, of the optical disk.

According to the present invention, there is provided a master disk for manufacturing optical disks comprising: a substrate having an optically flat surface, a first layer formed on the surface of said substrate so as to have a uniform thickness $\lambda$/8 consisting of a material capable of being changed by a first laser beam irradiation and having recesses, each prepared by removal of a first region thereof by irradiation with the first laser beam, said recesses being arranged at intervals in the circumferential direction of the disk, and a second layer formed on said first layer so as to have a uniform thickness $\lambda$/8 consisting of a material capable of being changed by a second laser beam irradiation and having a groove prepared by removal of a second region thereof by irradiation with the second layer beam, said groove extending in the circumferential direction of the disk, and said recess being formed in said first layer within said groove, said master disk being characterized in that the material of said second layer has a light sensitivity different from that of the material of said first layer, said second laser beam has a wavelength different from that of said first laser beam, said second layer has also a thickness substantially equal to T1 and said first layer has also a thickness substantially equal to T2 determined by the following formulas (1) and (2):

$$ T1 = (\frac{2n - 1}{4} - \frac{1}{8})\lambda \qquad (1) $$

$$ T2 = (\frac{2m}{4} + \frac{1}{8})\lambda - \frac{2n}{4}\lambda \qquad (2) $$

where n, m=1, 2, 3,..., except for n=m=1 and $\lambda$ represents the wavelength of a laser beam to be irradiated onto said optical disk, and said groove has a width substantially equal to Wo/2, and said recesses have a width substantially equal to Wo/3, Wo being defined as the diameter of a region in which the light intensity is at least $1/e^2$ of the maximum light intensity obtained in the light intensity distribution of a beam spot formed on the master disk.

According to the present invention there is also provided a method for manufacturing a master disk used in the manufacture of optical disks comprising: the step of applying a first converged laser beam intermittently onto an original disk including a substrate having an optically flat surface, a first layer formed on the surface of said substrate so as to have a uniform thickness $\lambda$/8 and formed of a material that can be changed upon irradiation of the first laser beam thereon and a second layer formed on said first layer so as to have a uniform thickness $\lambda$/8 and formed of a material that can be changed upon application of a second converged laser beam thereon, thereby forming first regions in said first layer arranged at intervals in the circumferential direction of the disk and the step of applying the second converged laser beam onto said original disk at least during the formation of said first regions, thereby forming a second region in said second layer which extends in the circumferential direction of the disk, said method being characterized in that the material of said second layer has a light sensitivity different from that of the first layer, said second laser beam has a wavelength different from that of said first laser beam, said second layer has a thickness substantially equal to T1 and said first layer has a thickness substantially equal to T2 determined by the following formulas:

$$ T1 = (\frac{2n - 1}{4} - \frac{1}{8})\lambda \qquad (1) $$

$$ T2 = (\frac{2m}{4} + \frac{1}{8})\lambda - \frac{2n}{4}\lambda \qquad (2) $$

where n, m=1, 2, 3,..., except for n=m=1 and $\lambda$ represents the wavelength of the laser beam to be applied to said optical disk, and said second region has a width substantially equal to Wo/2 and said first regions have a width substantially equal to Wo/3, Wo being defined as the diameter of a region in which the light intensity is at least $1/e^2$ of the maximum light intensity obtained in the light intensity distribution of a beam spot formed on the master disk.

According to the present invention there is also provided a system for use in manufacture of a master disk of optical disks comprising a turntable which is rotatable and on which an original disk of a master disk is to be mounted, an optical head which is used to expose said original disk of said master disk and which includes means for emitting a first laser beam, means for converting said first laser beam into one having a prescribed first diameter, first means for modulating the intensity of said first laser beam, means for emitting a second laser beam, means for converting said second laser beam into one having a prescribed second diameter, and second means for modulating the intensity of said second laser beam, and means for moving said optical head in the radial direction of said original disk, said system being characterized in that said second diameter is larger than said first diameter, said second laser beam has a wavelength different from that of said first laser beam and an objective lens converges said modulated first and second laser beams and projects these beams onto said original disk, thereby to concentrically form thereon first and second beam spots having different diameters.

This invention can be more fully understood from the following detailed description when taken in conjunction with the accompanying drawings, in which:

Fig. 1 is a perspective view of a master disk according to an embodiment of the invention;

Fig. 2 is a schematic view showing an optical system for manufacturing the master disk shown in Fig. 1; and

Figs. 3A to 3F are sectional views showing the process for manufacturing the optical disk from the master disk shown in Fig. 1.

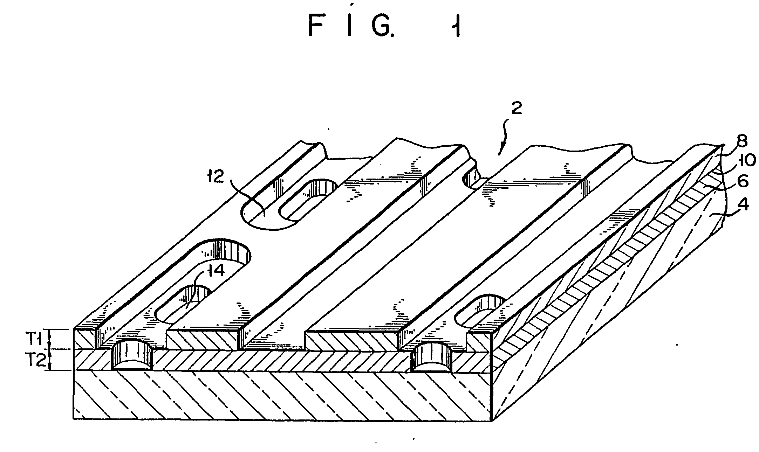

In Fig. 1, there is shown a master disk 2 which is used to manufacture optical disks according to an embodiment of the invention. This master disk 2 has a disk-like substrate with a surface ground and polished into an optically flat surface, (for example, a float glass plate 4 having a thickness of 8 mm). On the optically flat surface of this disk-like substrate 4, there is formed a first layer 6, on which a second layer 8 is formed through an adhesive agent, for example OAP (Trade Mark) manufactured by the Tokyo Ouka company or TRAN-SIL (Trade Mark) manufactured by Tran-sil Product incorporated, serving to increase the strength of adhesion between this second layer 8 and the first layer 6. First layer 6 and second layer 8 are formed of material that can change with respect to light or a laser beam, but, materials with different sensitivities are selectively used for the first and second layers, respectively. For example, selective use is made, for material in the first layer 6, of semi-metals such as Te, Bi, Se, etc. or metals such as Cr, Al, etc.. The compounds of these metals can be deformed or evaporated by heating, and the substances capable of being sublimed by heat such as nitrocellulose containing organic pigment or carbon, or photo-resist. Similarly, selective use is made, for material in the second layer, of substances that can be thermally sublimed such as nitrocellulose containing organic pigment or carbon, or photo-resist, or the like. For material in the first layer 6, use may be made of other substances with the capability of being thermally deformed or gasified (gasification is used, in this specification, to mean boiling, evaporation and sublimation). The thickness T1 of the second layer 8 is set at a value substantially equal to a depth H1 of a tracking guide of the optical disk, namely

$$\left(\frac{2n-1}{4}\lambda - \frac{\lambda}{8}\right).$$

The preferred thickness T2 of the first layer 6 is set at a value obtained by subtracting the depth H1 of the tracking guide from a depth H2 of pre-pits of the optical disk. The depth H2 of the pre-pits is determined to have a value of

$$\left(\frac{2m-1}{4}\lambda\right),$$

and the thickness T2 of the first layer is determined to a value (H2−H1). Note here that n and m and each integers, preferably n=m, and the $\lambda$ indicates the wavelength of a laser beam to be projected onto the optical disk from which information is read out and/or onto which information is recorded.

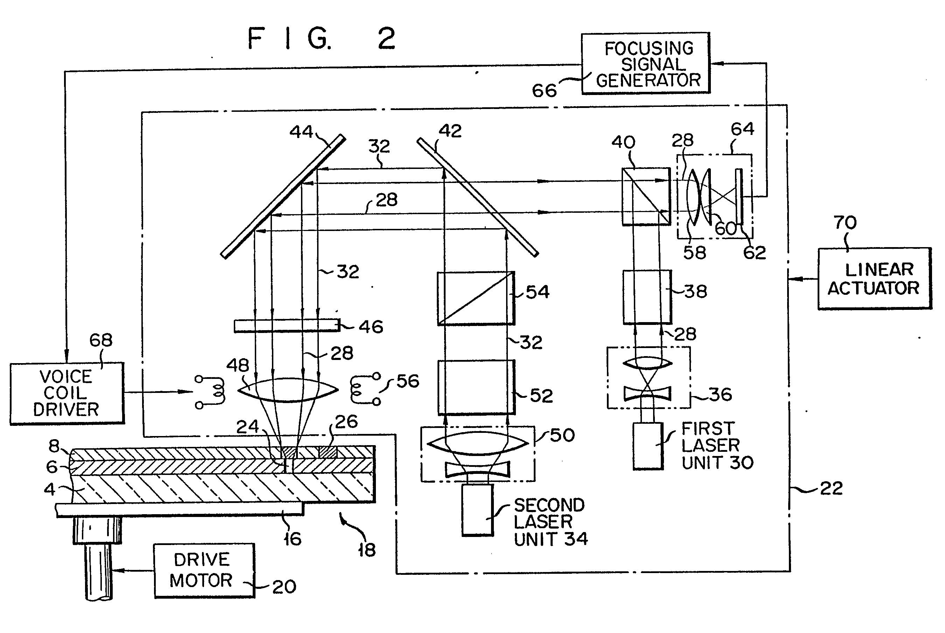

The above-mentioned first and second layers 6, 8 are spirally or concentrically formed, along the circumferential direction of the optical disk 2, with grooves 12 corresponding to the tracking guide and recesses 14 corresponding to the pre-pits, as shown in Fig. 1, by means of a system shown in Fig. 2 which will be described later. The width C1 of this groove 12 is set at a value of Wo/2 while the width C2 of the recess 14 at a value of Wo/3. It should be noted here that Wo is defined as the diameter of a region in which the light intensity is at least $1/e^2$ of the maximum light intensity obtained in the light intensity distribution of a beam spot formed on the master disk.

Next, the process for manufacturing the master disk 2 shown in Fig. 1, will be described with reference to Fig. 2. In the system shown in Fig. 2, an original disk 18 of the master disk 2 having the substrate 4 formed with the first and second layers 6, 8, thereon, without the groove 12 and recess 14, is put on a turntable 16 rotatable at constant linear velocity by a drive motor 20. In this embodiment, this original disk 18 is comprised of the second layer 8 consisting of a positive photoresist and the first layer 6 consisting of material containing Te as the main component and a suitable amount of carbon mixed therein. The first and second layers 6, 8 are subjected to light exposure by an exposing optical head 22 shown in Fig. 2 in such a manner that their first and second regions 24, 26, to be formed with the recesses 14 and grooves 12, respectively, are exposed to the light.

The exposing optical system 22 includes first and second laser units 30 and 34. Use is made, in the first laser unit 30, of a He—Ne laser unit capable of projecting He—Ne laser beams 28 to expose the first layer 6, that is, He—Ne laser beam 28 suitable for evaporating the Te constituting the material of the first layer 6. For the second laser unit 34, an Ar laser unit is used, which can emit an Ar laser beam 32 to the second layer 8. An Ar laser beam is considered optimum in view of spectral sensitivity of the photo-resist constituting the material of the second layer 8. The reason the first and second laser units 30, 34 emit laser beams of different wavelengths is that the laser beams can be separated by a dychroic mirror 42 even as they pass along the same optical path within the exposing optical system 22. The first laser beam 28 emitted from the first laser unit 30 passes through a collimator lens system 36 comprised of a divergent lens and convergent lens and is thus converted into a parallel laser beam having a prescribed diameter. The resultant laser beam 28 is subjected to light intensity modulation by a first modulator 38, or chopped thereby, according to the desired code information. The laser beam 28, thus chopped, is linearly polarized by means of a first polarization beam splitter 40 and is directed to a mirror 44 through the dychroic mirror 42 designed to reflect only the second laser beam 32. The laser beam 28 reflected from the mirror 44 is incident on an objective lens 48 through a $\lambda/4$ plate 46 along its optical axis, is converged and is thus projected onto the original disk 18 by the objective lens 48. The optical elements of a first optical system through which the first laser beam passes are arranged so that the first laser beam 28 projected onto the original disk 18 may have a first beam spot of substantially Wo/3 diameter on a boundary plane between the first and second layers 6 and 8. The second laser beam 32 emitted from the second laser unit 34, similarly, passes through a collimator lens system 50 comprised of a divergent lens and a convergent lens and is converted into a parallel laser beam having a prescribed beam diameter larger than that of the first laser beam 28. The second laser beam 32 is subjected to light intensity modulation or chopped by a second modulator 52 according to information regarding the region to be formed by a tracking guide. The laser beam, thus chopped, is linearly polarized by a second polarization beam splitter 54 and is then reflected by the dychronic mirror 42 and is directed to the mirror 44. The laser beam 32 thus reflected by this mirror 44 is allowed to pass through a λ/4 plate and then through an objective lens 48 along the optical axis to be projected onto the original disk 18. On the surface of the second layer 8 of the original disk 18, a second beam spot having a diameter of Wo/2 is formed, concentrically with said first beam spot, by an optical system through which the second laser beam 32 is allowed to pass.

In the above-mentioned optical system, when the objective lens 48 is kept out of focus, or in defocus-state in which the beam spot of prescribed diameter is not formed on the original disk 18 of the master disk 2, the objective lens 48 is moved along the optical axis by a voice coil 56, whereby the objective lens 48 is maintained in a state of "in-focus" wherein the beam spot having the prescribed diameter is formed on the original disk 18. That is, the first laser beam 28 reflected from the original disk 18 and allowed to pass through the objective lens 48, λ/4 plate 46, dychroic mirror 42 and beam splitter 40 is allowed to enter a focus detecting section 64 from known convergent lens 58, cylindrical lens 60 and photodetector device 62. In accordance with the photosignals generated from the photodetector device 62, a focussing signal generator 66 generates a focussing signal which is then applied to a voice coil driver 68 in a known manner. The voice coil 56 is thereby driven, and the objective lens 48 is kept in a constant state of "in-focus".

Any of the first and second laser beams 28, 32 reflected by the original disk 18 toward the first and second laser units 30, 34, are interrupted by the beam splitter 40 or 54, and the laser unit 30 or 34 is prevented from being brought to an undesired state.

As mentioned above, the first laser beam 28 is intermittently projected from the modulator 36 onto the original disk 18 rotating at a constant linear velocity and the second laser beam 32 is intermittently or continuously projected form the modulator 52 onto the rotating original disk. When such projection is made, the second layer 8 is exposed, by the second laser beam 32 and an exposed second region 26 having a prescribed width is intermittently or continuously in the circumferential direction of the original disk 18. On the other hand, the first laser beam 28 passes through the second layer 8 to reach the first layer 6 to cause the evaporation of Te of the first region 24, thereby causing this first region 24 to be recessed. Accordingly, the original disk 18 is formed with the exposed second region 26 in a circumferential direction and also intermittently formed, below the second region 26, with the recessed shaped first region 24. When, in the exposure process, the optical system 22 is moved by a linear actuator 70 in the radial direction of the original disk 18, this disk is formed with the first and second regions 24, 26, concentrically or spirally.

When the original disk 18, exposed in the above-mentioned process is subjected to a developing and fixing treatment, the second region 26 is removed, and a master disk 2 such as that shown in Fig. 1 is completed. By use of this master disk 2, an optical disk 72 is manufactured as follows.

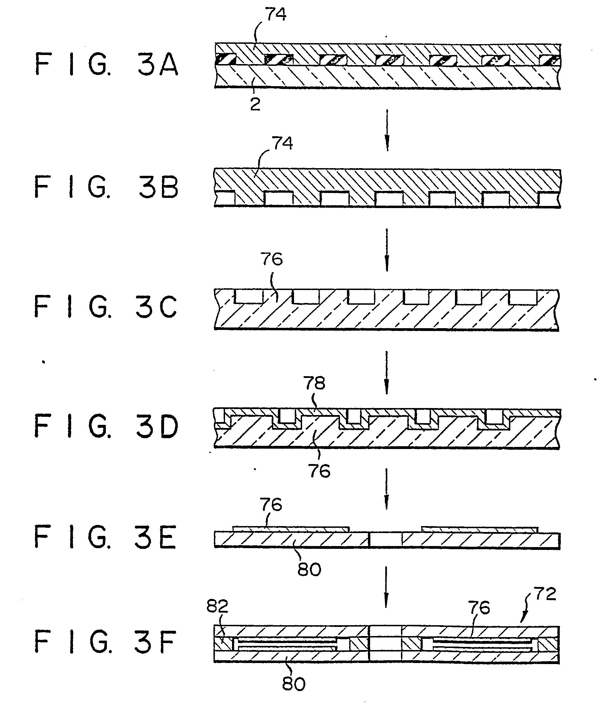

First, a master disk 2 is plated, as shown in Fig. 3A, to form the replica 74 shown in Fig. 3D. Then, a base disk 76 made of, e.g., transparent synthetic resin, as shown in Fig. 4C, is formed by the use of the replica 74 shown in Fig. 3B, and a metal layer is deposited on the surface of the base disk 76 to form a light reflective recording layer 78, shown in Fig. 3D. The base disk 76 is worked into a predetermined shape, and is pasted onto a disk plate 80 made of glass or some other material, as shown in Fig. 3E. A pair of disk plates 80, each provided with the base disk 76, are pasted together with a spacer 82 between them, as shown in Fig. 3F, to complete the optical disk 72.

As stated above, according to the present invention, it is possible to precisely form the region corresponding to the tracking guide and, during this formation, form the region corresponding to the pre-pits at the position located beneath that region. Thus, it is possible to more precisely manufacture the master disk for manufacturing the optical disk.

## Claims

1. A master disk for manufacturing optical disks comprising:

a substrate (4) having an optically flat surface,

a first layer (6) formed on the surface of said substrate (4) so as to have a uniform thickness λ/8, consisting of a material capable of being changed by a first laser beam (28) irradiation and having recesses (14), each prepared by removal of a first region (24) thereof by irradiation with the first laser beam (28), said recesses being arranged at intervals in the circumferential direction of the disk (2), and

a second layer (8) formed on said first layer (6) so as to have a uniform thickness λ/8 consisting of a material capable of being changed by a second laser beam (32) irradiation and having a groove (12) prepared by removal of a second region (26) thereof by irradiation with the second layer beam, said groove (12) extending in the circumferential direction of the disk (2), and said recess (14) being formed in said first layer (6) within said groove (12), characterized in that

the material of said second layer (8) has a light sensitivity different from that of the material of said first layer (6), said second laser beam (32) has a wavelength different from that of said first laser beam (28),

said second layer (8) has also a thickness substantially equal to T1 and said first layer (6) has also a thickness substantially equal to T2 determined by the following formulas (1) and (2):

$$T1 = (\frac{2n-1}{4} - \frac{1}{8})\lambda \qquad (1)$$

$$T2 = (\frac{2m}{4} + \frac{1}{8})\lambda - \frac{2n}{4}\lambda \qquad (2)$$

where n, m=1, 2, 3,..., except for n=m=1 and $\lambda$ represents the wavelength of a laser beam to be irradiated onto said optical disk, and

said groove (12) has a width substantially equal to Wo/2, and said recesses (14) have a width substantially equal to Wo/3, Wo being defined as the diameter of a region in which the light intensity is at least $1/e^2$ of the maximum light intensity obtained in the light intensity distribution of a beam spot formed on the master disk (2).

2. A master disk according to claim 1, characterised in that said recesses (14) correspond to pre-pits of said optical disk and said groove (12) corresponds to a tracking guide of said optical disk.

3. A master disk according to claim 1, characterised in that said first layer (6) is formed of a material capable of being deformed or gasified by heat generated by laser beam (28) applied to said second layer (8) formed of photo-resist.

4. A method for manufacturing a master disk used in the manufacture of optical disks comprising:

the step of applying a first converged laser beam (28) intermittently onto an original disk (18) including a substrate (4) having an optically flat surface, a first layer (6) formed on the surface of said substrate (4) so as to have a uniform thickness $\lambda/8$ and formed of a material that can be changed upon irradiation of the first laser beam (28) thereon and a second layer (8) formed on said first layer (6) so as to have a uniform thickness $\lambda/8$ and formed of a material that can be changed upon application of a second converged laser beam (32) thereon, thereby forming first regions (24) in said first layer (6) arranged at intervals in the circumferential direction of the disk (2) and the step of applying the second converged laser beam (32) onto said original disk (18) at least during the formation of said first regions, thereby forming a second region (26) in said second layer (8) which extends in the circumferential direction of the disk, characterized in that

the material of said second layer (8) has a light sensitivity different from that of the first layer (6),

said second laser beam (32) has a wavelength different from that of said first laser beam (28),

said second layer (8) has a thickness substantially equal to T1 and said first layer (6) has a thickness substantially equal to T2 determined by the following formulas:

$$T1 = (\frac{2n-1}{4} - \frac{1}{8})\lambda \qquad (1)$$

$$T2 = (\frac{2m}{4} + \frac{1}{8})\lambda - \frac{2n}{4}\lambda \qquad (2)$$

where n, m=1, 2, 3,..., except to n=m=1 and $\lambda$ represents the wavelength of the laser beam to be applied to said optical disk, and

said second region (26) has a width substantially equal to Wo/2 and said first regions (24) have a width substantially equal to Wo/3, Wo being defined as the diameter of a region in which the light intensity is at least $1/e^2$ of the maximum light intensity obtained in the light intensity distribution of a beam spot formed on the master disk (2).

5. A method according to claim 4, characterized by further comprising the step of removing said second region (26).

6. A method according to claim 5, characterized by further comprising the step of removing said first regions (24).

7. A method according to claim 4, characterized in that said first and second converged laser beams (28, 32) have different wavelengths, respectively.

8. A method according to claim 4, characterized in that said first and second converged laser beams (28, 32) are projected onto the original disk (18) through a common optical path.

9. A system for use in manufacture of a master disk of optical disks comprising

a turntable (16) which is rotatable and on which an original disk (18) of a master disk (2) is to be mounted,

an optical head (22) which is used to expose said original disk (18) of said master disk (2) and which includes means (30) for emitting a first laser beam (28), means for converting said first laser beam (28) into one having a prescribed first diameter, first means (36) for modulating the intensity of said first laser beam (28), means (34) for emitting a second laser beam (32), means for converting said second laser beam (32) into one having a prescribed second diameter, and second means for modulating the intensity of said second laser beam (32), and means (70) for moving said optical head (22) in the radial direction of said original disk (2), characterized in that:

said second diameter is larger than said first diameter,

said second laser beam (32) has a wavelength different from that of said first laser beam (28), and

an objective lens (48) converges said modulated first and second laser beams (28, 32) and projects these beams (28, 32) onto said original disk (18), thereby to concentrically form thereon first and second beam spots having different diameters.

10. A system according to claim 9, characterized in that said optical head (22) includes a means (56) for moving said objective lens (48) along an optical axis thereof.

11. A system according to claim 10, characterized by further comprising means for energizing said moving means (56) by sensing one of said first and second laser beams (28, 32) reflected from said original disk (18), thereby moving said objective lens (48) to keep the beam spots at a prescribed diameter at all times.

## Patentansprüche

1. Matrizenplatte zur Herstellung von optischen Platten, umfassend

ein Substrat (4) mit einer optisch flachen Oberfläche,

eine erste Schicht (6), die auf der Oberfläche des Substrats (4) so ausgebildet ist, daß sie eine gleichmäßige Dicke von λ/8 aufweist, und die aus einem durch Bestrahlung mittels eines ersten Laserstrahls (28) veränderbaren Werkstoff besteht und Vertiefungen (14) aufweist, die jeweils durch Abtragen eines ersten Bereichs (24) derselben durch Bestrahlung mit dem ersten Laserstrahl (28) ausgebildet und in Umfangsrichtung der Platte (2) in Abständen angeordnet sind, und

eine zweite Schicht (8), die auf der ersten Schicht (6) so geformt ist, daß sie eine gleichmäßige Dicke von λ/8 aufweist, die aus einem durch Bestrahlung mittels eines zweiten Laserstrahls (32) veränderbaren Werkstoff besteht und eine durch Abtragen eines zweiten Bereichs (26) derselben durch Bestrahlung mit dem zweiten Laserstrahl erzeugte Rille (12) aufweist, welche in Umfangsrichtung der Platte (2) verläuft, wobei die Vertiefung(en) (14) in der ersten Schicht (6) innerhalb der Rille (12) ausgebildet ist (sind), dadurch gekennzeichnet, daß

der Werkstoff der zweiten Schicht (8) eine von der Lichtempfindlichkeit des Werkstoffs der ersten Schicht (6) verschiedene Lichtempfindlichkeit besitzt, wobei der zweite Laserstrahl (32) eine von der Wellenlänge des ersten Laserstrahls (28) verschiedene Wellenlänge aufweist,

die zweite Schicht (8) auch eine Dicke praktisch gleich T1 besitzt und die erste Schicht (6) zudem eine Dicke praktisch gleich T2 aufweist, welche sich nach folgenden Formeln bzw. Gleichungen bestimmen:

$$T1 = (\frac{2n-1}{4} - \frac{1}{8})\lambda \qquad (1)$$

$$T2 = (\frac{2m}{4} + \frac{1}{8})\lambda - \frac{2n}{4}\lambda \qquad (2)$$

wobei in diesen Gleichungen bedeuten: n, m=1, 2, 3,... außer für n=m=1, und λ=die Wellenlänge eines auf die optische Platte aufzustrahlenden Laserstrahls, und

die Rille (12) eine Breite praktisch gleich Wo/2 und die Vertiefungen (14) eine Breite praktisch gleich Wo/3 besitzen, wobei Wo als der Durchmesser eines Bereichs definiert ist, in welchem die Lichtintensität oder -stärke mindestens $1/e^2$ der maximalen Lichtintensität oder -stärke beträgt, die in der Lichtintensitätsverteilung eines auf der Matrizenplatte (2) erzeugten Strahlflecks erreicht wird.

2. Matrizenplatte nach Anspruch 1, dadurch gekennzeichnet, daß die Vertiefungen Vorgrübchen oder -pits der optischen Platte entsprechen und die Rille (12) einer Spurführung(srille) der optischen Platte entspricht.

3. Matrizenplatte nach Anspruch 1, dadurch gekennzeichnet, daß die erste Schicht (6) aus einem Werkstoff geformt ist, der durch die von einem Laserstrahl (28), der auf die aus einem Photoresistmaterial deformte zweite Schicht (6) geworfen wird, erzeugte Wärme verformbar oder vergasbar ist.

4. Verfahren zur Herstellung einer Matrizenplatte für die Herstellung von optischen Platten, umfassend

einen Schritt einer intermittierenden Aufstrahlung eines ersten konvergierten Laserstrahls (28) auf eine Originalplatte (18) mit einem eine optisch flache Oberfläche aufweisenden Substrat (4), einer auf der Oberfläche des Substrats (4) mit einer gleichmäßigen Dicke von λ/8 geformten ersten Schicht (6) aus einem Werkstoff, der durch Aufstrahlung des ersten Laserstrahls (28) veränderbar ist, und einer auf der ersten Schicht (6) mit einer gleichmäßigen Dicke von λ/8 geformten zweiten Schicht (8) aus einem Werkstoff, der durch Aufstrahlung eines zweiten, konvergierten Laserstrahls (32) veränderbar ist, so daß in der ersten Schicht (6) erste, in Umfangsrichtung der Platte (2) auf Abstände angeordnete Bereiche (24) geformt werden, und einen Schritt der Aufstrahlung des zweiten, konvergierten Laserstrahls (32) auf die Originalplatte (18) zumindest während der Ausbildung der ersten Bereiche, um damit in der zweiten Schicht (8) einen zweiten, sich in Umfangsrichtung der Platte erstreckenden Bereich (26) zu formen, dadurch gekennzeichnet, daß

der Werkstoff der zweiten Schicht (8) eine von der Lichtempfindlichkeit der ersten Schicht (6) verschiedene Lichtempfindlichkeit aufweist,

der zweite Laserstrahl (32) eine von der Wellenlänge des ersten Laserstrahls (28) verschiedene Wellenlänge besitzt,

die zweite Schicht (8) eine Dicke praktisch gleich T1 aufweist und die erste Schicht (6) eine Dicke praktisch gleich T2 besitzt, die sich nach folgenden Formeln bzw. Gleichungen bestimmen:

$$T1 = (\frac{2n-1}{4} - \frac{1}{8})\lambda \qquad (1)$$

$$T2 = (\frac{2m}{4} + \frac{1}{8})\lambda - \frac{2n}{4}\lambda \qquad (2)$$

wobei in diesen Gleichungen bedeuten: n, m=1, 2, 3,..., außer für n=m=1, und λ=Wellenlänge des

auf die optische Platte aufzustrahlenden Laserstrahle, und

der zweite Bereich (26) eine Breite praktisch gleich Wo/2 und die ersten Bereichs (24) eine Breite praktisch gleich Wo/3 besitzen, wobei Wo als der Durchmesser eines Bereichs definiert ist, in welchem die Lichtintensität oder -stärke mindestens $1/e^2$ der maximalen Lichtintensität oder -stärke beträgt, die in der Lichtintensitätsverteilung eines auf der Matrizenplatte (2) erzeugten Strahlflecks erreicht wird.

5. Verfahren nach Anspruch 4, gekennzeichnet durch einen weiteren Schritt eines Entfernens oder Abtragens des zweiten Bereichs (26).

6. Verfahren nach Anspruch 5, gekennzeichnet durch den weiteren Schritt eines Entfernens oder Abtragens der ersten Bereichs (24).

7. Verfahren nach Anspruch 4, dadurch gekennzeichnet, daß die ersten und zweiten konvergierten Laserstrahlen (28, 32) jeweils verschiedene Wellenlängen besitzen.

8. Verfahren nach Anspruch 4, dadurch gekennzeichnet, daß erster und zweiter konvergierter Laserstrahl (28, 32) über einen gemeinsamen Strahlengang auf die Originalplatte (18) projiziert werden.

9. System zur Herstellung einer Matrizenplatte für optische Platten, umfassend

einen drehbaren Plattenteller (16), auf dem eine Originalplatte (18) für eine Matrizenplatte ·(2) montierbar ist,

einen zum Belichten der Originalplatte (18) der Matrizenplatte (2) dienenden optischen Kopf (22) mit einer Einheit (30) zum Emittieren eines ersten Laserstrahls (28), einer Einheit zum Umwandeln des ersten Laserstrahls (28) in einen solchen eines vorbestimmten ersten Durchmessers, einer ersten Einheit (36) zum Modulieren der Intensität des ersten Laserstrahls (28), einer Einheit (34) zum Emittieren eines zweiten Laserstrahls (32), einer Einheit zum Umwandeln des zweiten Laserstrahls (32) in einen solchen mit einem vorbestimmten zweiten Durchmesser und einer zweiten Einheit zum Modulieren der Intensität des zweiten Laserstrahls (32), sowie

eine Einheit (70) zum Bewegen bzw. Führen des optischen Kopfes (22) in Radialrichtung der Originalplatte (2), dadurch gekennzeichnet, daß

der zweite Durchmesser größer ist als der erste Durchmesser,

der zweite Laserstrahl (32) eine von der Wellenlänge des ersten Laserstrahls (28) verschiedene Wellenlänge besitzt und

eine Objektivlinse (48) die modulierten ersten und zweiten Laserstrahlen konvergiert und diese Strahlen (28, 32) auf die Originalplatte (18) projiziert, um auf dieser konzentrisch erste und zweite Strahlflecke unterschiedlicher Durchmesser zu erzeugen.

10. System nach Anspruch 9, dadurch gekennzeichnet, daß der optische Kopf (22) eine Einheit (56) zum Bewegen oder Führen der Objektivlinse (48) längs ihrer optischen Achse aufweist.

11. System nach Anspruch 10, gekennzeichnet durch eine Einrichtung zum Erregen oder Aktivieren der Bewegungseinheit (56) durch Messen eines der ersten und zweiten, von der Originalplatte (18) reflektierten Laserstrahlen (28, 32), um damit die Objektivlinse (48) so zu bewegen oder zu führen, daß die Strahlflecke jederzeit auf einem vorbestimmten Durchmesser gehalten werden.

**Revendications**

1. Un disque matrice pour la fabrication de disques optiques comprenant:

un substrat (4) ayant une surface optiquement plane,

une première couche (6) formée sur la surface de ce substrat (4) de façon à avoir une épaisseur uniforme de $\lambda/8$, consistant en un matériau capable de subir un changement sous l'action de l'irradiation par un premier faisceau laser (28) et comportant des cavités (14), chacune d'elles étant préparée par enlèvement d'une première région (24) de cette couche par irradiation avec le premier faisceau laser (28), ces cavités étant disposées à des intervalles dans la direction de la circonférence du disque (2), et

une seconde couche (8) formée sur la première couche (6) de façon à avoir une épaisseur uniforme de $\lambda/8$, consistant en un matériau capable de subir un changement sous l'effet de l'irradiation par un second faisceau laser (32), et comportant un sillcon (12) préparé par l'enlèvement d'une seconde région (26) de cette couche, par irradiation avec le second faisceau laser, ce sillon (12) s'étendant dans la direction de la circonférence du disque (2), et les cavités (14) étant formées dans la première couche (6) à l'intérieur du sillon (12), caractérisé en ce que

le matériau de la seconde couche (8) a une sensibilité à la lumière qui est différente de celle du matériau de la première couche (6), le second faisceau laser (32) a une longueur d'onde différente de celle du premier faisceau laser (28),

la seconde couche (8) a également une épaisseur pratiquement égale à T1 et la première couche (6) a également une épaisseur pratiquement égale à T2, déterminées par les formules (1) et (2) suivantes:

$$T1 = \left(\frac{2n-1}{4} - \frac{1}{8}\right)\lambda \qquad (1)$$

$$T2 = \left(\frac{2m}{4} + \frac{1}{8}\right)\lambda - \frac{2n}{4}\lambda \qquad (2)$$

dans lesquelles n, m=1, 2, 3,..., les valeurs n=m=1 exceptées, et $\lambda$ représente la longueur d'onde d'un faisceau laser à projeter sur le disque optique, et

le sillon (12) a une largeur pratiquement égale à Wo/2, et les cavités (14) ont une largeur pratiquement égale à Wo/3, Wo étant défini comme étant le diamètre d'une région dans laquelle l'intensité lumineuse est au moins égale à la fraction $1/e^2$ de l'intensité lumineuse maximale obtenue dans la distribution d'intensité lumineuse d'une trace de faisceau qui est formée sur le disque matrice (2).

2. Un disque matrice selon la revendication 1, caractérisé en ce que les cavités (14) correspondant à des cuvettes pré-formées du disque optique, et le sillon (12) correspond à un guide de suivi de piste du disque optique.

3. Un disque matrice selon la revendication 1, caractérisé en ce que la première couche (6) est formée par un matériau susceptible d'être déformé ou transformé en gaz par de la chaleur produite par le faisceau laser (28) qui est appliqué à la seconde couche (8), constituée par une matière de réserve photographique.

4. Un procédé de fabrication d'un disque matrice utilisé dans la fabrication de disques optiques, comprenant:

l'étape consistant à appliquer de façon intermittente un premier faisceau laser focalisé (28) sur un disque vierge (18) comprenant un substrat (4) ayant une surface optiquement plane, une première couche (6) formée sur la surface de ce substrat (4) de façon à avoir une épaisseur uniforme de $\lambda/8$, et constituée par un matériau qui peut subir un changement sous l'effet de l'irradiation de cette couche par le premier faisceau laser (28), et une seconde couche (8) formée sur la première couche (6) de façon à avoir une épaisseur uniforme de $\lambda/8$, et constituée par un matériau capable de subir un changement sous l'effet de l'application à cette couche d'un second faisceau laser focalisé (32), pour former ainsi dans la première couche (6) des premières régions (24) disposées à des intervalles dans la direction de la circonférence du disque (2), et l'étape consistant à appliquer le second faisceau laser focalisé (32) au disque vierge (18) au moins pendant la formation des premières régions, pour former ainsi dans la seconde couche (8) une seconde région (26) qui s'étend dans la direction de la circonférence du disque, caractérisé en ce que

le matériau de la seconde couche (8) a une sensiblité à la lumière différente de celle du matériau de la première couche (6),

le second faisceau laser (32) a une longueur d'onde différente de celle du premier faisceau laser (28),

la seconde couche (8) a une épaisseur pratiquement égale à T1 et la première couche (6) a une épaisseur pratiquement égale à T2, déterminées par les formules suivantes:

$$T1 = (\frac{2n-1}{4} - \frac{1}{8})\lambda \qquad (1)$$

$$T2 = (\frac{2m}{4} + \frac{1}{8})\lambda - \frac{2n}{4}\lambda \qquad (2)$$

dans lesquelles n, m=1, 2, 3,..., les valeurs n=m=1 exceptées, et $\lambda$ représente la longueur d'onde du faisceau laser qui est appliqué au disque optique, et

la seconde région (26) a une largeur pratiquement égale à Wo/2 et les premières régions (24) ont une largeur pratiquement égale à Wo/3, Wo étant défini comme étant le diamètre d'une région dans laquelle l'intensité lumineuse est au moins égale à la fraction $1/e^2$ de l'intensité lumineuse maximale qui est obtenue dans la distribution d'intensité lumineuse d'une trace de faisceau formée sur le disque matrice (2).

5. Un procédé selon la revendication 4, caractérisé en ce qu'il comprend en outre l'étape consistant à enlever la seconde région (26).

6. Un procédé selon la revendication 5, caractérisé en ce qu'il comprend en outre l'étape consistant à enlever les premières régions (24).

7. Un procédé selon la revendication 4, caractérisé en ce que les premier et second faisceaux laser focalisés (28, 32) ont respectivement les longueurs d'onde différentes.

8. Un procédé selon la revendication 4, caractérisé en ce que les premier et second faisceaux laser focalisés (28, 32) sont projetés sur le disque vierge (18) selon un chemin optique commun.

9. Un système prévu pour l'utilisation dans la fabrication d'un disque matrice pour des disques optiques, comprenant:

un plateau tournant (16) qui peut être mis en rotation et sur lequel on peut monter un disque vierge (18) pour un disque matrice (2),

une tête optique (22) qu'on utilise pour exposer le disque vierge (18) pour le disque matrice (2), et qui comprend des moyens (30) destinés à émettre un premier faisceau laser (28), des moyens pour convertir le premier faisceau laser (28) en un faisceau ayant un premier diamètre déterminé, des premiers moyens (36) pour moduler l'intensité du premier faisceau laser (28), des moyens (34) pour émettre un second faisceau laser (32), des moyens pour convertir le second faisceau laser (32) en un faisceau ayant un second diamètre déterminé, et des seconds moyens pour moduler l'intensité du second faisceau laser (32), et

des moyens (70) pour déplacer la tête optique (22) dans la direction radiale du disque vierge (18), caractérisé en ce que:

le second diamètre est supérieur au premier diamètre,

le second faisceau laser (32) a une longueur d'onde différente de celle du premier faisceau laser (28), et

un objectif (48) focalise les premier et second faisceaux laser (28, 32) et il projette ces faisceaux (28, 32) sur le disque vierge (18), pour former ainsi de façon concentrique sur ce fernier des première et seconde traces de faisceau ayant des diamètres différentes.

10. Un système selon la revendication 9, caractérisé en ce que la tête optique (22) comprend des moyens (56) pour déplacer l'objectif (48) dans la direction de son axe optique.

11. Un système selon la revendication 10, caractérisé en ce qu'il comprend en outre des moyens destinés à exciter les moyens de déplacement (56) en détectant l'un des premier et second faisceaux laser (28, 32) réfléchis à partir du disque vierge (18), pour déplacer ainsi l'objectif (48) afin de toujours maintenir les traces de faisceau à un diamètre déterminé.

F I G. 1

2

12

14

T1
T2

8
10
6
4

F I G. 2

F I G. 3A

74

2

F I G. 3B

74

F I G. 3C

76

F I G. 3D

78

76

F I G. 3E

76

80

F I G. 3F

82

76

72

80